# EUROPEAN PATENT APPLICATION

(11) **EP 4 465 354 A1**
(43) Date of publication of application: **20.11.2024**
(21) Application number: 24172427.7
(22) Date of filing: 25.04.2024
(51) Int. Cl.: H01L 25/075, H01L 25/16, H01L 33/62

(54) **MICRO LED DISPLAY PANEL**

(30) Priority: 05.05.2023 WO PCT/CN2023/092170
(71) Applicant: Jade Bird Display (Shanghai) Limited, Shanghai 200120 (CN)
(72) Inventor: XU, Qunchao, Shanghai (CN); TAI, Weisin, Shanghai (CN)
(74) Representative: Finnegan Europe LLP

(57) **Abstract**

A micro LED display panel includes: a micro LED array including a plurality of micro LEDs; an integrated circuit (IC) backplane formed at a back surface of the micro LED array; and a plurality of interconnected structures configured to electrically respectively connect the light emitting mesas. The interconnected structures include one or more top interconnected structures configured to electrically connect to a top of each one of the two or more light emitting mesas and be bonded with the IC backplane, and one or more bottom interconnected structures each configured to electrically connect to a bottom of one of the two or more light emitting mesas and be bonded with the IC backplane, the interconnected structures being formed around the two or more light emitting mesas, a top of the plurality of interconnected structures is equal to or higher than a top of a top-most light emitting mesa.

## Description

### CROSS-REFERENCE TO RELATED APPLICATIONS

The present disclosure claims priority to and the benefits of PCT Application No. PCT/CN2023/092170, filed on May 5, 2023, which is incorporated herein by reference in its entirety.

### TECHNICAL FIELD

The present disclosure generally relates to micro LED manufacturing technology, and more particularly, to a micro LED display panel.

### BACKGROUND

Inorganic micro pixel light emitting diodes, also referred to as micro light emitting diodes, micro LEDs, or µ-LEDs, become more important since they are used in various applications including self-emissive micro-displays, visible light communications, and optogenetics. The micro LEDs have higher output performance than conventional LEDs because of better strain relaxation, improved light extraction efficiency, and uniform current spreading. Compared with conventional LEDs, the micro LEDs also exhibit several advantages, such as improved thermal effects, faster response rate, larger working temperature range, higher resolution, wider color gamut, higher contrast, lower power consumption, and operability at higher current density.

Conventionally, the micro LEDs can include multiple light emitting mesas, and each light emitting mesa can be electrically connected to a respective electrode, so that each light emitting mesa can be controlled. A micro LED display panel may include an array of micro LEDs. Therefore, for a micro LED display panel, such connections for each light emitting mesa of each micro LED occupies significant space within the micro LED display panel, which could constrain arranging more micro LEDs on the micro LED display panel.

### SUMMARY OF THE DISCLOSURE

Embodiments of the present disclosure provide a micro LED display panel. The micro LED display panel includes: a micro LED array including a plurality of micro LEDs, wherein each one of the plurality of micro LEDs includes two or more light emitting mesas which are disposed in a vertical direction from top to bottom; an integrated circuit (IC) backplane formed at a back surface of the micro LED array and configured to control the plurality of micro LEDs; and a plurality of interconnected structures configured to electrically respectively connect the light emitting mesas, wherein the interconnected structures comprise one or more top interconnected structures configured to electrically connect to a top of each one of the two or more light emitting mesas and be bonded with the IC backplane, and one or more bottom interconnected structures each configured to electrically connect to a bottom of one of the two or more light emitting mesas and be bonded with the IC backplane, the interconnected structures being formed around the two or more light emitting mesas, one of the bottom interconnected structures connected to one light emitting mesa, and one of the top interconnected structures connected to each one of the two or more light emitting mesas; wherein a top of the plurality of interconnected structures is equal to or higher than a top of a top-most light emitting mesa.

According to the micro LED display panel provided by the embodiments of the present disclosure, a plurality of interconnected structures are provided around a pixel display area of a micro LED, and extended from top to bottom of the micro LED. Therefore, the plurality of interconnected structures may provide optical isolation and prevent light across talk between adjacent micro LEDs, thereby improving light emitting efficiency.

### BRIEF DESCRIPTION OF THE DRAWINGS

Embodiments and various aspects of the present disclosure are illustrated in the following detailed description and the accompanying figures. Various features shown in the figures are not drawn to scale.
**FIG. 1** illustrates a structural diagram showing a top view of a micro LED display panel, according to some embodiments of the present disclosure.
**FIG. 2** illustrates a structural diagram showing a top view of an exemplary micro LED, according to some embodiments of the present disclosure.
**FIG. 3A** illustrates a structural diagram showing a section view of the micro LED along a section line A-A' direction shown in **FIG. 2****,** according to some embodiments of the present disclosure.
**FIG. 3B** illustrates a structural diagram showing a sectional view of the micro LED along a section line B-B' direction shown in **FIG. 2****,** according to some embodiments of the present disclosure.
**FIG. 3C** illustrates a structural diagram showing a sectional view of the micro LED along a section line C-C' direction shown in **FIG. 2****,** according to some embodiments of the present disclosure.
**FIG. 3D** illustrates a structural diagram showing another example sectional view of micro LED along a section line C-C' direction shown in **FIG. 2****,** according to some embodiments of the present disclosure.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims. Particular aspects of the present disclosure are described in greater detail below. The terms and definitions provided herein control, if in conflict with terms and/or definitions incorporated by reference.

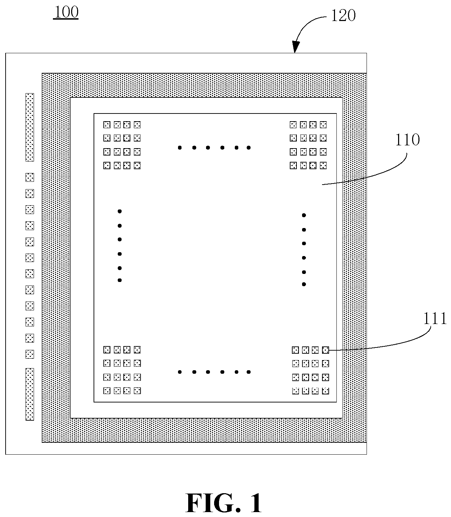

**FIG. 1** illustrates a structural diagram showing a top view of a micro LED display panel 100, according to some embodiments of the present disclosure. Referring to **FIG. 1****,** micro LED display panel 100 includes a micro LED array 110 and an IC (integrated circuit) backplane 120. Micro LED array 110 is located on IC backplane 120 to form an image display area of micro LED display panel 100. The rest of the area on IC backplane 120 not covered by micro LED array 110 is formed as a non-functional area. IC backplane 120 is formed at the back surface of micro LED array 110 with a part extending outside of, i.e., not covered by, micro LED array 110. Micro LED array 110 includes a plurality of micro LEDs 111 provided in an array. IC backplane 120 is configured to control the plurality of micro LEDs 111.

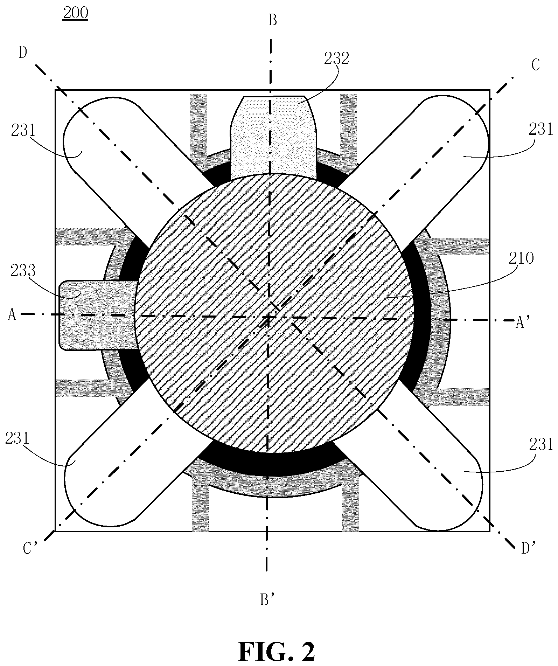

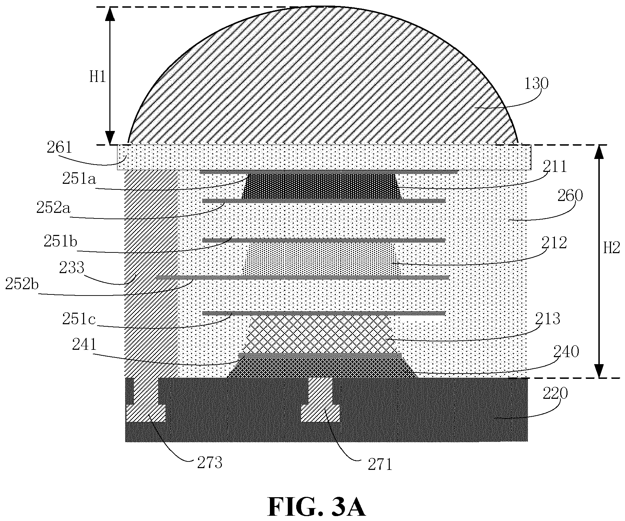

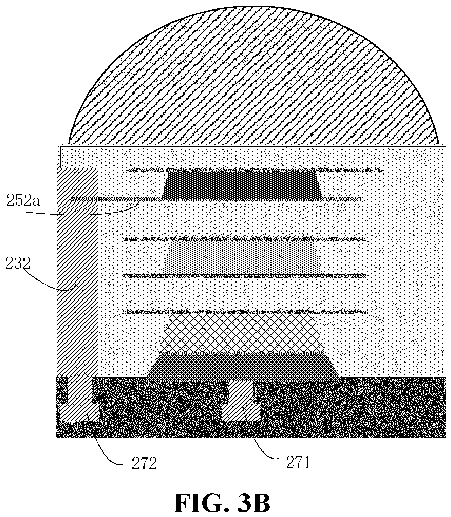

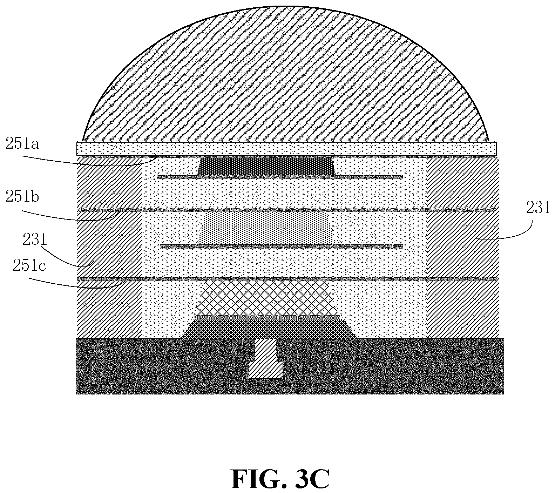

**FIG. 2** illustrates a structural diagram showing a top view of an exemplary micro LED 200, according to some embodiments of the present disclosure. Micro LED 200 can be used in micro LED display panel 100 as shown in **FIG. 1****.** It can be understood that the components shown in **FIG. 2** with internal structure exposed are only for illustrative purposes. **FIG. 3A** illustrates a structural diagram showing a sectional view of micro LED 200 along a section line A-A' direction shown in **FIG. 2****,** according to some embodiments of the present disclosure. **FIG. 3B** illustrates a structural diagram showing a sectional view of micro LED 200 along a section line B-B' direction shown in **FIG. 2****,** according to some embodiments of the present disclosure. **FIG. 3C** illustrates a structural diagram showing a sectional view of micro LED 200 along a section line C-C' direction shown in **FIG. 2****,** according to some embodiments of the present disclosure. Referring to **FIG. 2** and **FIGs. 3A** to **3C,** micro LED 200 includes a pixel display area 210 including two or more light emitting mesas, for example, a first light emitting mesa 211 (i.e., a top-most light emitting mesa), a second light emitting mesa 212, and a third light emitting mesa 213 (i.e., a bottom-most light emitting mesa), which are disposed in a vertical direction from top to bottom. For example, in some embodiments, first light emitting mesa 211 is a blue light emitting mesa, second light emitting mesa 212 is a green light emitting mesa, and third light emitting mesa 213 is a red light emitting mesa. In some embodiments, first light emitting mesa 211 is a green light emitting mesa, second light emitting mesa 212 is a blue light emitting mesa, and third light emitting mesa 213 is a red light emitting mesa. In some embodiments, the light emitting mesas may include the same color light. For example, first light emitting mesa 211 can be a green light emitting mesa, while both second light emitting mesa 212 and third light emitting mesa 213 are red light emitting mesas. The three light emitting mesas (i.e., mesas 211 to 213) are arranged in a relative sense, in a vertical direction, from top to bottom. That is, second light emitting mesa 212 is disposed over third light emitting mesa 213, and first light emitting mesa 211 is disposed over second light emitting mesa 212. In some embodiments, the bottom most light emitting mesa (i.e., third light emitting mesa 213) is a red light emitting mesa, and the top most light emitting mesa (i.e., first light emitting mesa 211) is a green light emitting mesa.

In some embodiments, a vertical distance between two adjacent light emitting mesas is the same. In some embodiments, the distance between two adjacent light emitting mesas may vary, depending on a design practice. In some embodiments, a diameter of a top surface of each one of the light emitting mesas (i.e., mesas 211 to 213) is smaller than a diameter of a bottom surface of the corresponding light emitting mesa. That is, a diameter of a top surface of first light emitting mesa 211 is smaller than a diameter of a bottom surface of first light emitting mesa 211; a diameter of a top surface of second light emitting mesa 212 is smaller than a diameter of a bottom surface of second light emitting mesa 212; and a diameter of a top surface of third light emitting mesa 213 is smaller than a diameter of a bottom surface of third light emitting mesa 213.

In some embodiments, the light emitting mesas are arranged coaxially. That is, vertical projections of the respective light emitting mesas are overlapped. In some embodiments, the size (e.g., top surface area) of light emitting mesas can be different. Then, the vertical projections of the respective light emitting mesas may be partially overlapped.

Micro LED 200 further includes a plurality of interconnected structures configured to electrically respectively connect the light emitting mesas (i.e., mesas 211 to 213). The interconnected structures include one or more top interconnected structures 231 and one or more bottom interconnected structures (e.g., 232 and 233). Top interconnected structure 231 is configured to electrically connect to a top of each of the light emitting mesas (i.e., mesas 211 to 213). A bottom of top interconnected structure 231 is bonded with IC backplane 220, but not electrically connected with IC backplane 220. Top interconnected structure 231 can connect the top of each light emitting mesa to a first electrode (for example, a negative electrode). Each bottom interconnected structure (i.e., 232 and 233) is configured to electrically connect to a bottom of one of the light emitting mesas (i.e., mesas 211 to 213). A bottom of each bottom interconnected structure (i.e., 232 and 233) is bonded with IC backplane 220 and electrically connected with IC backplane 220. Each bottom interconnected structure (i.e., 232 and 233) can connect the bottom of a light emitting mesa to a second electrode (for example, a positive electrode). The interconnected structures are formed around the light emitting mesas (i.e., mesas 211 to 213). One top interconnected structure connects to all of the light emitting mesas (i.e., mesas 211 to 213), and one bottom interconnected structure connects to one light emitting mesa. For example, referring to **FIG. 3C****,** top interconnected structure 231 connects to the top of each of the three light emitting mesas (i.e., mesas 211 to 213). Referring to **FIG. 3B****,** a first bottom interconnected structure 232 is only connected to the bottom of first light emitting mesa 211. Referring to **FIG. 3A****,** a second bottom interconnect structure 233 is only connected to the bottom of a second light emitting mesa 212. One bottom interconnected structure (i.e., 232 or 233) is used for one light emitting mesa of one micro LED only. A adjacent micro LEDs do not share the bottom interconnected structures. Referring to **FIG. 2****,** multiple top interconnected structures 231 may be provided. For example, micro LED 200 includes four top interconnected structures 231 provided along the section line C-C' direction and a section line D-D' direction. All the four top interconnected structures 231 are connected to all the light emitting mesas (i.e., mesas 211 to 213). It can be understood that a sectional view of micro LED 200 along a section line D-D' direction shown in **FIG. 2** and a sectional view of micro LED 200 along a section line C-C' direction shown in **FIG. 2** could be the same as shown in **FIG. 3C****.**

A top of the plurality of interconnected structures (i.e., 231 to 233) is at a vertical position (as viewed in **FIGs. 3A-3C**) equal to or higher than a top of first light emitting mesa 211, and the bottoms of the plurality of interconnected structures are bonded with IC backplane 220. Therefore, the plurality of interconnected structures (i.e., 231 to 233) can provide optical isolation between adjacent micro LEDs. It can be understood that **FIG. 2** only illustrates one arrangement of the plurality of the interconnected structures. In some embodiments, the plurality of interconnected structures can be in a different arrangement.

According to the micro LED display panel provided in the embodiments of the present disclosure, a plurality of interconnected structures are provided around a pixel display area of a micro LED, and extended from top to bottom of the micro LED. Therefore, the plurality of interconnected structures may provide optical isolation and prevent light across talk between adjacent micro LEDs, thereby improving light emitting efficiency.

In some embodiments, the interconnected structures (e.g., top interconnected structure 231 and bottom interconnected structures 232 and 233) are made of conductive metal. In some embodiments, the interconnected structures are through-vias, which are made of metal and with a hollow structure.

In some embodiments, the interconnected structures are further configured to reflect light emitted from the light emitting mesas and prevent light across talk between adjacent micro LEDs, thereby improving the light emitting efficiency.

In some embodiments, micro LED 200 further includes a bottom bonding layer 240 provided between a bottom of third light emitting mesa 213 and IC backplane 220. That is, third light emitting mesa 213 (i.e., the bottom-most light emitting mesa) is bonded to IC backplane 220 via bottom bonding layer 240 rather than a bottom interconnected structure. In some embodiments, a material of bottom bonding layer 240 is metal. For example, the material may include: Al, Au, Rh, Ag, Cr, Ti, Pt, Sn, Cu, etc. The material may also include metal alloys, for example, AuSn, TiW, and the like. In some embodiments, a diameter of a top surface of bottom bonding layer 240 is equal to a diameter of a bottom surface of third light emitting mesa 213. The diameter of a top surface of bottom bonding layer 240 is equal to or smaller than a diameter of a bottom surface of bottom bonding layer 240. In some embodiments, micro LED 200 further includes a conductive film 241 provided between bottom bonding layer 240 and third light emitting mesa 213. Conductive film 241 may provide an ohmic contact between bottom bonding layer 240 and third light emitting mesa 213, and conductive film 241 together with the top surface of bottom bonding layer 240 can form an omni-directional reflector (ODR) structure with high reflectivity. In some embodiments, conductive film 241 is a TCO (transparent conductive oxide) thin film, for example, an ITO (Indium Tin Oxide) film, an AZO (Antimony doped Zinc Oxide) film, an ATO (Antimony doped Tin Oxide) film, an FTO (Fluorine doped Tin Oxide) film, or the like.

In some embodiments, micro LED 200 further includes a conductive layer network structure. The conductive layer network structure is configured to connect each light emitting mesa to the plurality of interconnected structures. In some embodiments, the conductive layer network structure includes one or more top conductive layers and one or more bottom conductive layers, for example, top conductive layers 251a to 251c and bottom conductive layers 252a and 252b. A first bottom conductive layer 252a is formed on a back surface of first light emitting mesa 211 and extends to connect first light emitting mesa 211 with first bottom interconnected structure 232 (as shown in **FIG. 3B**). A second bottom conductive layers 252b is formed on a back surface of second light emitting mesa 212 and extends to connect second light emitting mesa 212 with second bottom interconnected structure 233 (as shown in **FIG. 3A**). Top conductive layers 251a to 251c are formed on a top surface of each of first light emitting mesa 211, second light emitting mesa 212, and third light emitting mesa 213, respectively, and configured to connect the light emitting mesas (i.e., mesas 211 to 213) with top interconnected structure 231 (as shown in **FIG. 3C**). Each top or bottom conductive layer is configured to connect a corresponding light emitting mesa. First bottom conductive layer 252a for first light emitting mesa 211 is not connected with second bottom interconnected structure 233. Second bottom conductive layer 252b for second light emitting mesa 212 is not connected with first bottom interconnected structure 232.

In some embodiments, referring to **FIG. 3C****,** top conductive layers 251a to 251c are extended to connect the light emitting mesas (e.g., mesas 211 to 213) with top interconnected structure 231 directly. In this example, top conductive layer (e.g., 251a to 251c) may be continuously formed between adjacent micro LEDs.

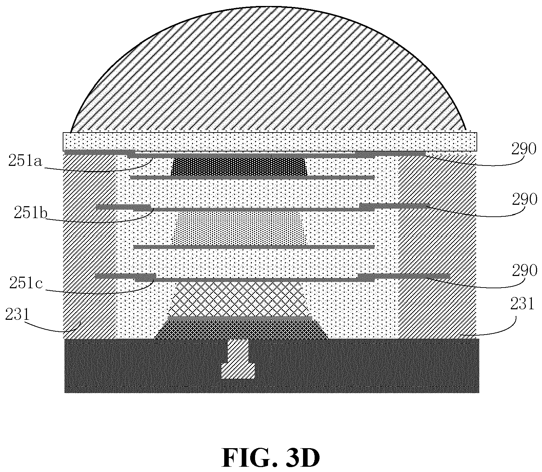

**FIG. 3D** illustrates a structural diagram showing another example section view of micro LED along section line C-C' direction shown in **FIG. 2****,** according to some embodiments of the present disclosure. Referring to **FIG. 3D****,** in some embodiments, micro LED 200 further includes an interconnected layer 290. A first end of interconnected layer 290 is formed on an edge of top conductive layer (e.g., layers 251a to 251c), a second end of interconnected layer 290 is connected to top interconnect structure 231, so that each of the top conductive layer is connected to top interconnected structure 231 by interconnected layer 290.

In some embodiments, the conductive layers are transparent. The material of each conductive layer is one or more of Indium Tin Oxide (ITO), Fluorine-doped Tin Oxide (FTO), or Aluminum-doped Zinc Oxide (AZO), etc.

Referring again to **FIG. 3A****,** in some embodiments, micro LED 200 further includes a dielectric material 260 filled between light emitting mesas (e.g., mesas 211 to 213) and around the interconnected structures. In some embodiments, the dielectric material 260 may be formed as a dielectric layer, which is provided between the adjacent light emitting mesas. For example, a first dielectric layer is formed on a bottom of first bottom conductive layer 252a, a second dielectric layer is formed on a top of second top conductive layer 251b. The first dielectric layer is bonded with the second dielectric layer. A third dielectric layer is formed on a bottom of second bottom conductive layer 252b, and a fourth dielectric layer is formed on a top of third top conductive layer 251c. The third dielectric layer is bonded with the fourth dielectric layer. In some embodiments, dielectric material 260 fills the space within micro LED 200. In some embodiments, dielectric material 260 is transparent. In some embodiments, dielectric material 260 includes one or more of SiO₂, SiON, Al₂O₃, or SiN, etc.

In some embodiments, micro LED display panel 100 further includes a top dielectric layer 261 (referring to **FIG. 3A**) continuously formed on a top surface of the micro LED array. In some embodiments, top dielectric layer 261 is transparent. In some embodiments, a material of top dielectric layer 261 includes one or more of SiO₂, SiON, Al₂O₃, or SiN, etc.

Referring to **FIG. 1** and **FIG. 2****,** in some embodiments, micro LED display panel 100 further includes a plurality of micro lenses provided on top dielectric layer 261. Each one of the micro lenses covers pixel display area 210 of one micro LED. As shown in **FIG. 3A****,** a micro lens 130 is provided corresponding to micro LED 200. In some embodiments, a diameter of a bottom surface of micro lens 130 is greater than a largest diameter of top surfaces of the two or more light emitting mesas. For example, the diameter of the bottom surface of micro lens 130 is greater than a diameter of a top surface of first light emitting mesa 211, a diameter of a top surface of second light emitting mesa 212, and a diameter of a top surface of third light emitting mesa 213. In some embodiments, a height H1 of micro lens 130 is equal to or less than 10 µm (micron). In some embodiments, the material of micro lens 130 is selected from silicon oxide, photo resist, etc.

In some embodiments, a height H2 of micro LED 200 is from 1 µm to 10 µm. In some embodiments, a height of each light emitting mesa (i.e., mesas 211 to 213) is from 0.3 µm to 3.5 µm.

Referring to **FIG. 1****,** in some embodiments, IC backplane 120 further includes an array of pad groups (not shown) corresponding to micro LED array 110. One pad group corresponds to one micro LED 111. Referring to **FIG. 2** to **FIG. 3A** to **3C,** for example, a pad group includes three pads. A first pad 271 is connected to bottom bonding layer 240. A second pad 272 is connected to first bottom interconnected structure 232 connecting with a bottom of first light emitting mesa 211 (shown in **FIG. 3B**). A third pad 273 is connected to second bottom interconnected structure 233 connected with the bottom of second light emitting mesa 212 (shown in **FIG. 3A**). Therefore, the pad group can be configured to control the three light emitting mesas 211 to 213 independently.

The micro LED herein, e.g., micro LED 200, has a very small volume. The micro LED can be applied in a micro LED display panel. The light emitting area of the micro LED display panel, e.g., micro LED display panel 100, is very small, such as 1mm×1mm, 3mm×5 mm, etc. In some embodiments, the light emitting area is the area of the micro LED array in the micro LED display panel. The micro LED display panel includes one or more micro LED arrays that form a pixel array in which the micro LEDs are pixels, such as a 1600×1200, 680×480, or 1920×1080-pixel array. The diameter of the micro LED is in the range of about 200nm to 2µm. An IC backplane, e.g., IC backplane 120, is formed at the back surface of the micro LED array and is electrically connected with the micro LED array. The IC backplane acquires signals such as image data from outside via signal lines to control corresponding micro LEDs to emit light or not.

It is understood by those skilled in the art that the micro LED display panel is not limited by the structure described above, and may include greater or fewer components than those illustrated, or some components may be combined, or a different component may be utilized.

It should be noted that relational terms herein such as "first" and "second" are used only to differentiate an entity or operation from another entity or operation, and do not require or imply any actual relationship or sequence between these entities or operations. Moreover, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items.

As used herein, unless specifically stated otherwise, the term "or" encompasses all possible combinations, except where infeasible. For example, if it is stated that a database may include A or B, then, unless specifically stated otherwise or infeasible, the database may include A, or B, or A and B. As a second example, if it is stated that a database may include A, B, or C, then, unless specifically stated otherwise or infeasible, the database may include A, or B, or C, or A and B, or A and C, or B and C, or A and B and C.

In the foregoing specification, embodiments have been described with reference to numerous specific details that can vary from implementation to implementation. Certain adaptations and modifications of the described embodiments can be made. Other embodiments can be apparent to those skilled in the art from consideration of the specification and practice of the invention disclosed herein. It is intended that the specification and examples be considered as exemplary only, with a true scope of the invention being indicated by the following claims. It is also intended that the sequence of steps shown in figures are only for illustrative purposes and are not intended to be limited to any particular sequence of steps. As such, those skilled in the art can appreciate that these steps can be performed in a different order while implementing the same method.

In the drawings and specification, there have been disclosed exemplary embodiments. However, many variations and modifications can be made to these embodiments. Accordingly, although specific terms are employed, they are used in a generic and descriptive sense only and not for purposes of limitation.

## Claims

1. A micro LED display panel, comprising:
a micro LED array comprising a plurality of micro LEDs, wherein each one of the plurality of micro LEDs comprises two or more light emitting mesas which are disposed in a vertical direction from top to bottom;
an integrated circuit (IC) backplane formed at a back surface of the micro LED array and configured to control the plurality of micro LEDs; and
a plurality of interconnected structures configured to electrically respectively connect the light emitting mesas, wherein the interconnected structures comprise one or more top interconnected structures configured to electrically connect to a top of each one of the two or more light emitting mesas and be bonded with the IC backplane, and one or more bottom interconnected structures each configured to electrically connect to a bottom of one of the two or more light emitting mesas and be bonded with the IC backplane, the interconnected structures being formed around the two or more light emitting mesas, one of the bottom interconnected structures connected to one light emitting mesa, and one of the top interconnected structures connected to each one of the two or more light emitting mesas; wherein a top of the plurality of interconnected structures is equal to or higher than a top of a top-most light emitting mesa.

2. The micro LED display panel according to claim 1, wherein a diameter of a top surface of each one of the light emitting mesas is smaller than a diameter of a bottom surface of the light emitting mesa.

3. The micro LED display panel according to claim 1, wherein the micro LED further comprises a bottom bonding layer provided between a bottom of a bottom-most one of the light emitting mesas and the IC backplane.

4. The micro LED display panel according to claim 3, wherein a material of the bottom bonding layer is metal.

5. The micro LED display panel according to claim 4, wherein the material of the bottom bonding layer comprises at least one of Al, Au, Rh, Ag, Cr, Ti, Pt, Sn, Cu, AuSn, or TiW.

6. The micro LED display panel according to claim 3, wherein a diameter of a top surface of the bottom bonding layer is equal to a diameter of a bottom surface of the bottom-most light emitting mesa.

7. The micro LED display panel according to claim 1, wherein the micro LED further comprises a conductive layer network structure configured to connect the two or more light emitting mesas to the plurality of interconnected structures.

8. The micro LED display panel according to claim 7, wherein the conductive layer network structure comprises a top conductive layer formed on a top surface of each of the light emitting mesas and configured to connect the light emitting mesa with the top interconnected structure, and a bottom conductive layer formed at a bottom surface of each of the light emitting mesas and configured to connect the light emitting mesa with the bottom interconnected structure.

9. The micro LED display panel according to claim 8, wherein the top conductive layer is extended to connect the light emitting mesa with the top interconnected structure.

10. The micro LED display panel according to claim 9, wherein the top conductive layer is continuously formed between adjacent micro LEDs.

11. The micro LED display panel according to claim 8, the micro LED further comprises an interconnected layer, wherein a first end of the interconnected layer is formed on an edge of the top conductive layer and a second end of the interconnected layer is connected to the top interconnect structure.

12. The micro LED display panel according to claim 7, wherein the conductive layer network structure is transparent.

13. The micro LED display panel according to claim 12, wherein a material of the conductive layer network structure is one of Indium Tin Oxide (ITO), Fluorine-doped Tin Oxide (FTO), or Aluminum-doped Zinc Oxide (AZO).

14. The micro LED display panel according to claim 1, wherein the interconnected structures are made of conductive metal.

15. The micro LED display panel according to claim 14, wherein the interconnected structures are through-vias.

16. The micro LED display panel according to claim 1, the micro LED further comprises a dielectric material filled between the light emitting mesas and around the interconnected structures.

17. The micro LED display panel according to claim 16, further comprising a top dielectric layer continuously formed on a top surface of the micro LED array.

18. The micro LED display panel according to claim 17, wherein the top dielectric layer is transparent.

19. The micro LED display panel according to claim 18, wherein material of the top dielectric layer is SiO₂, SiN, SiON, or Al₂O₃.

20. The micro LED display panel according to claim 17, further comprising a plurality of micro lenses provided on the top dielectric layer, each of the micro lenses covering a pixel display area of one of the micro LEDs.

21. The micro LED display panel according to claim 20, wherein a diameter of a bottom surface of the micro lens is greater than a largest diameter of top surfaces of the two or more light emitting mesas.

22. The micro LED display panel according to claim 21, wherein a height of the micro lens is equal to or less than 10 µm.

23. The micro LED display panel according to claim 3, wherein the IC backplane comprises an array of pad groups corresponding to the micro LED array, one of the pad groups corresponding to one micro LED, the two or more light emitting mesas comprise a first light emitting mesa, a second light emitting mesa and a third light emitting mesa which are disposed in the vertical direction from top to bottom, wherein the pad group comprises:
a first pad connected to the bottom bonding layer;
a second pad connected to a first one of the bottom interconnected structures connected with a bottom of the first light emitting mesa; and
a third pad connected to a second one of the bottom interconnected structures connected with a bottom of the second light emitting mesa.

24. The micro LED display panel according to claim 23, wherein the first light emitting mesa emits blue light; the second light emitting mesa emits green light; and the third light emitting mesa emits red light.

25. The micro LED display panel according to claim 1, wherein a height of the micro LED is from 1 µm to 10 µm.

26. The micro LED display panel according to claim 25, wherein a height of one of the light emitting mesas is from 0.3 µm to 3.5 µm.

27. The micro LED display panel according to claim 1, wherein a bottom most light emitting mesa of the two or more light emitting mesas emits red light.

28. The micro LED display panel according to claim 27, wherein a top most light emitting mesa emits green light.
